# EUROPEAN PATENT SPECIFICATION

(11) **EP 2 892 312 B1**
(45) Date of publication and mention of the grant of the patent: **06.11.2019**
(21) Application number: 12883759.8
(22) Date of filing: 31.08.2012
(51) Int. Cl.: H05K 13/04

(54) **COMPONENT MOUNTING MACHINE**
MASCHINE ZUR MONTAGE VON KOMPONENTEN
MACHINE DE MONTAGE DE COMPOSANT

(43) Date of publication of application: 08.07.2015
(73) Proprietor: FUJI Corporation, Chiryu Aichi (JP)
(72) Inventor: NISHIYAMA, Satoru, Chiryu Aichi (JP)
(74) Representative: Grünecker Patent- und Rechtsanwälte PartG mbB
(86) International application number: PCT/JP2012/072121
(87) International publication number: WO 2014/033900

(56) References cited:
- JP-A- 2003 347 796
- JP-A- 2004 006 512
- JP-A- 2005 123 371
- JP-A- 2005 302 945
- JP-A- 2006 269 794
- JP-A- 2012 134 258
- US-A- 4 621 854
- US-A1- 2002 083 584
- US-A1- 2006 111 222
- US-A1- 2012 151 756

## Description

### Technical Field

This present invention relates to a component mounter equipped with a head which holds multiple suction nozzles that pick up components.

### Background Art

The component mounter disclosed in patent literature 1 (Japanese Patent Publication Number 4546857) comprises a rotary head holding multiple suction nozzles, wherein the rotary head is attached and held to a head holding section of a component mounter using negative pressure suction force in order to be capable of being automatically exchanged according to circumstances such as the type (size, shape, and so on) of components.

On the other hand, the component mounter described in patent literature 2 (Japanese Unexamined Patent Application Publication Number 2006-216627), in order for a suction nozzle being held by a mounting head to be able to be automatically exchanged according to circumstances such as the type (size, shape, and so on) of components, is provided with a nozzle holding mechanism on the mounting head, and suction nozzles are exchangeably held on this nozzle holding mechanism.

US2012/151756A1 discloses a component mounter with exchangeable rotary heads.

US2006/111222A1 discloses a component mounter with a rotary head having exchangeable nozzles incorporating a nozzle storing device.

US2002/083584A1 discloses a component mounter with exchangeable nozzles, wherein the nozzle holding portion has an inverted-J-shaped groove.

US4621854A relates to a device for changing tools, wherein a member to be engaged is provided at a connecting section of the tool; a J shape engaging member which moves between an engagement position engaging with the member to be engaged and an engagement release position released from the engagement is provided on a lower section of the device; and an air cylinder which is a driving source to move the engaging member between the engagement position and the engagement release position is provided on the device.

### Citation List

### Patent Literature

Patent Literature 1: Japanese Patent Publication Number 4546857
Patent Literature 2: Japanese Unexamined Patent Application Publication Number 2006-216627

### Summary of Invention

### Problem to be Solved by the Invention

With the above current component mounters, because the configuration is such that only either of a rotary head (mounting head) or suction nozzle can be automatically exchanged, depending on the types of components to be mounted on a board, there are cases in which an operator needs to manually exchange a rotary head or exchange a suction nozzle, this was a cause of reducing the operation rate of the component mounter.

Therefore, the object of the present invention is to make it possible to perform automatic exchange of a head and automatic exchange of a suction nozzle of a component mounter by appropriately selecting them.

### Means for Solving the Problem

In order to solve the above problem, the present invention is a component mounter according to claim 1. According to this configuration, it possible to perform automatic exchange of a head and automatic exchange of a suction nozzle of a component mounter by appropriately selecting them and the time required for exchanging a head or suction nozzle can be shortened, thus the operation rate of a component mounter can be improved.

In this case, it is good to have a configuration in which a head rotating mechanism for rotating a head and a nozzle rotating mechanism for correcting the orientation of each component picked up by the suction nozzle by rotating the suction nozzle are assembled on a head holding unit. Thus, a head rotating mechanism and nozzle rotating mechanism can be shared for use for all heads for exchange and it is not required to assemble a head rotating mechanism or nozzle rotating mechanism to a head for exchange, thus enabling downsizing and cost reduction of a head for exchange, and space saving for exchange work.

Also, it is acceptable to have a configuration such that: a nozzle holder for holding a suction nozzle is lowerably held on the head; an engagement protruding section is provided protruding to the side on the upper section of the suction nozzle; an engagement groove with an inverted L shape or inverted J shape into which the engagement protruding section is inserted from below is formed in an engagement cylindrical section which engages the upper section of the suction nozzle in the nozzle holder; and a spring to maintain the state in which the engagement protruding section is engaged with the engagement groove is provided in the nozzle holder. By doing this, a suction nozzle can be held mechanically in a nozzle holder by the engagement of the engagement protruding section at the suction nozzle side and the engagement groove at the nozzle holder side, and positional deviation or dropping of a suction nozzle due to the inertia force can be prevented even if a head is moved at a high speed. However, for the present invention, it is also acceptable for a suction nozzle to be held in a nozzle holder using a plunger or plate spring.

Also, it is acceptable to have a configuration such that: a member to be engaged is provided in a connecting section with the head holding unit in a head; an L shape or J shape engaging member which moves between an engagement position engaging with the member to be engaged and an engagement release position released from the engagement is provided on a lower section of the head holding unit; and an air cylinder which is a driving source to move the engaging member between the engagement position and the engagement release position is provided on the head holding unit. By doing this, a head can be held mechanically on the head holding unit by the engagement between an engaging member with an L shape or J shape at the head holding unit side and a member to be engaged at the head side, and positional deviation or dropping of a head due to the inertia force can be prevented even if a head is moved at a high speed. However, for the present invention, it is also acceptable for a head to be picked and held on a head holding unit using negative pressure suction force.

### Brief Description of Drawings

[FIG. 1]

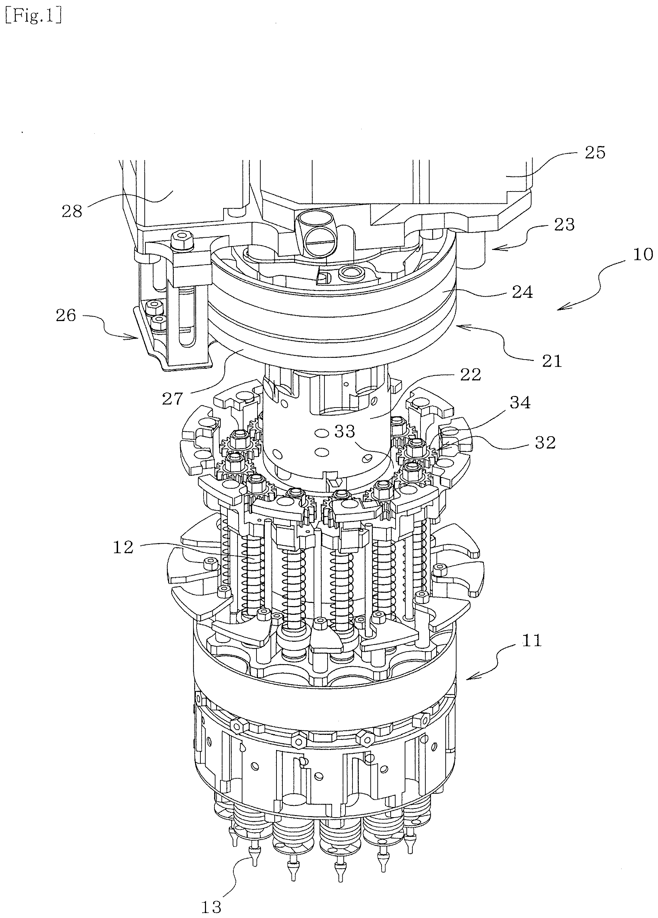

   FIG. 1 is a perspective view showing an embodiment of the present invention, in which a rotary head is shown removed from the head holding unit of the component pickup device.
[FIG. 2]

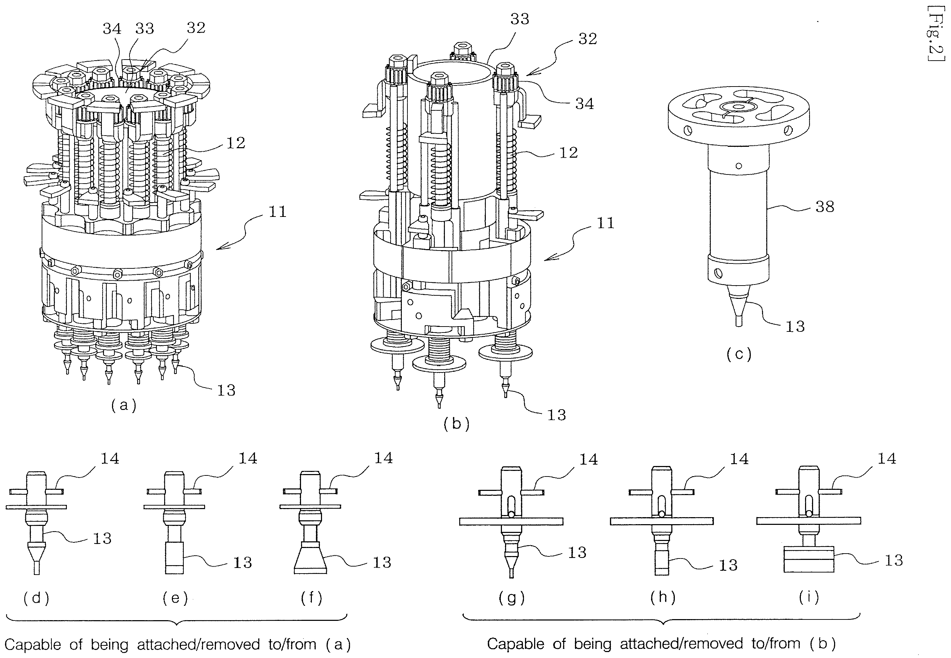

   FIG. 2 (a) to (i) are perspective views showing an example of an exchangeable rotary head and an exchangeable suction nozzle.
[FIG. 3]

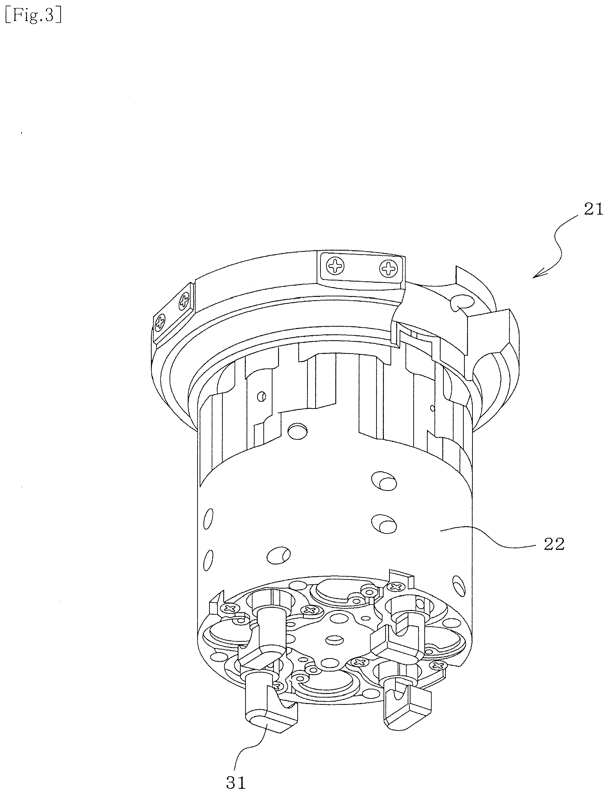

   FIG. 3 is a perspective view showing the R-axis section of a head holding unit.
[FIG. 4]

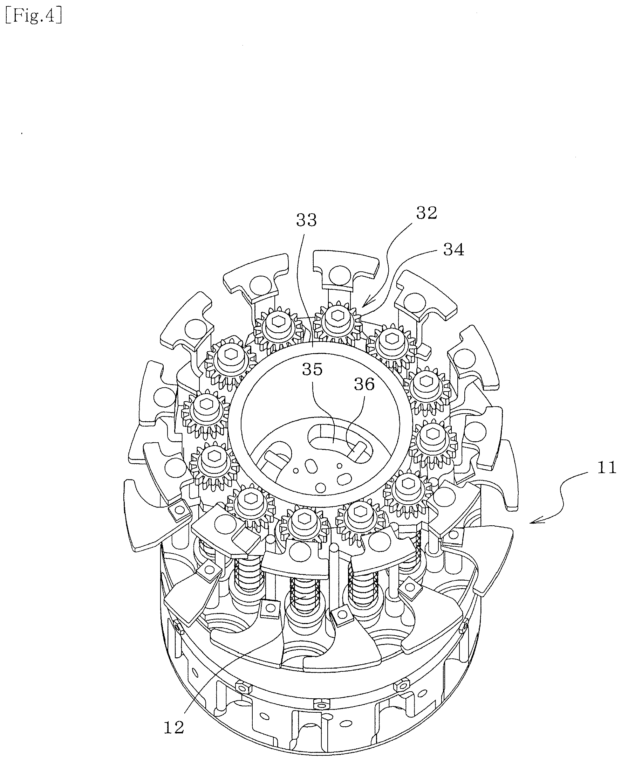

   FIG. 4 is a perspective view of a rotary head.
[FIG. 5]

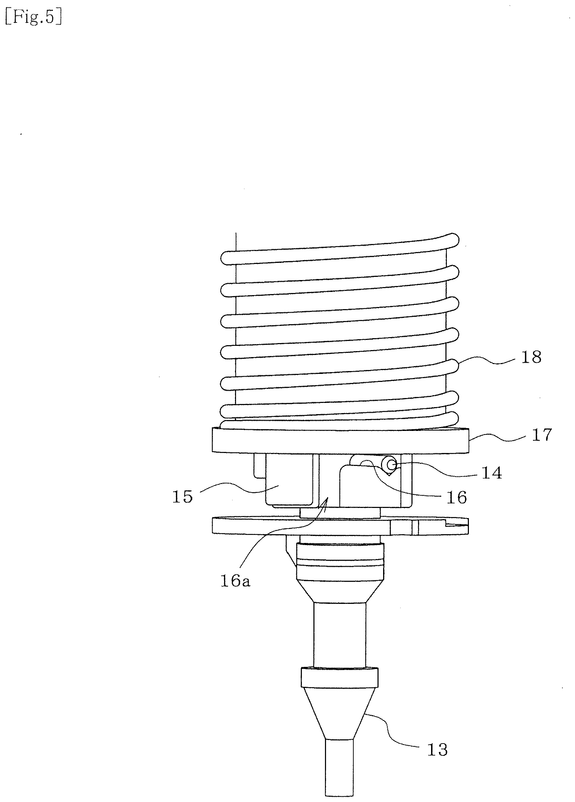

   FIG. 5 is a perspective view showing the engagement holding structure of a suction nozzle.
[FIG. 6]

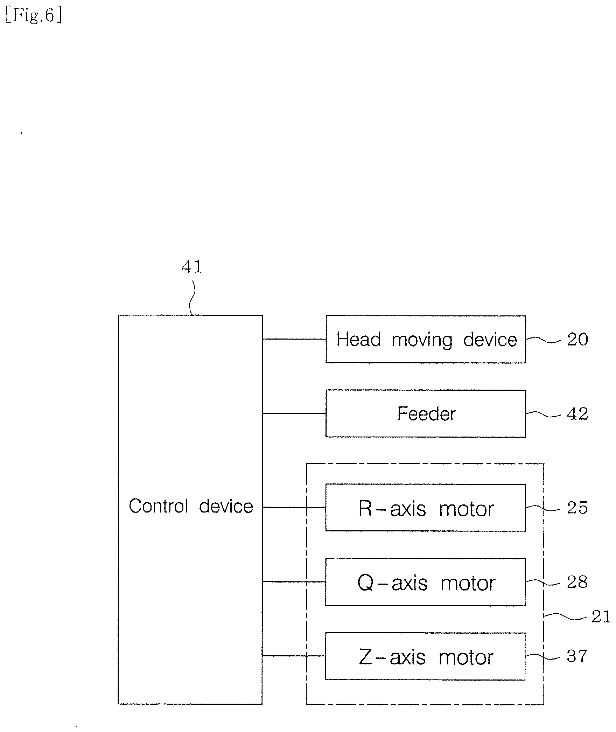

   FIG. 6 is a block diagram showing the configuration of control items of the component mounter.

### Description of Embodiments

The following describes a specific embodiment for carrying out the present invention. First, the configuration of component pickup device 10 of a component mounter is described.

Multiple nozzle holders 12 are lowerably held in a circumferential direction at predetermined intervals on rotary head 11 (head) of component pickup device 10, and suction nozzles 13 which pick up each component are exchangeably (detachably) engaged and held facing downwards on the lower section of each nozzle holder 12.

Here, the engagement holding structure of suction nozzle 13 is described using FIG. 2 and FIG. 5. On the upper section of suction nozzle 13, engagement pin 14 (engagement protruding section) is provided protruding in the diameter direction. In contrast, as shown in FIG. 5, in engagement cylindrical section 15 which engages the upper section of suction nozzle 13 in nozzle holder 12, engagement groove 16 (bayonet type engagement groove) with an inverted L shape or inverted J shape into which engagement pin 14 is inserted from below is formed. Further, in engagement cylindrical section 15 of nozzle holder 12, cylindrical pressing member 17 is engaged to be capable of moving up and down, and the pressing member 17 is pushed down by spring 18 (spring).

A component mounter is provided with a nozzle placement section (not shown in the figure) on which suction nozzles 13 for exchange are placed. This nozzle placement section is configured such that multiple types of suction nozzles 13 (refer to FIG. 2) can be placed in a state with rotation being stopped (a state in which engagement pin 14 is positioned in a predetermined direction). When attaching suction nozzle 13 placed on this nozzle placement section to nozzle holder 12, first, rotary head 11 is moved above the nozzle placement section by head moving device 20 (refer to FIG. 6), nozzle holder 12 to which suction nozzle 13 is to be attached is positioned directly above the suction nozzle 13, and inlet 16a of engagement groove 16 in engagement cylindrical section 15 of the nozzle holder 12 is entered into a state being positioned at engagement pin 14 of suction nozzle 13. In this state, rotary head 11 is lowered, and after engagement cylindrical section 15 of nozzle holder 12 is pushed into the upper section of suction nozzle 13 and inlet 16a of engagement groove 16 in engagement cylindrical section 15 is inserted into engagement pin 14 of suction nozzle 13, by rotating the nozzle holder 12 in the engagement direction (the end direction of engagement groove 16), engagement pin 14 of suction nozzle 13 is engaged with the V-shaped recess section of engagement groove 16 of the nozzle holder 12. This engaged state is kept by engagement pin 14 being pressed to the V-shaped recess section of engagement groove 16 by pressing member 17 by the spring force of spring 18. When suction nozzle 13 is removed from nozzle holder 12, it is good to remove it in the order reverse to the above, and suction nozzle 13 removed from nozzle holder 12 is placed on the nozzle placement section.

Rotary head 11 is exchangeably (detachably) held on R axis 22 (refer to FIG. 1, FIG. 3) extending downward of head holding unit 21 which is moved by head moving device 20. R-axis driving mechanism 23 (head rotating mechanism) which rotates R axis 22 is assembled on head holding unit 21. R-axis driving mechanism 23 rotates R-axis gear 24 (tooth surface is not shown in the figure) fixed on the upper end of R axis 22 by R-axis motor 25 and rotates rotary head 11 around R axis 22, thus multiple nozzle holders 12 rotate in a circumferential direction of the rotary head 11 integrally with multiple suction nozzles 13.

In R axis 22, Q-axis gear 27 (tooth surface is not shown in the figure) which is a driving source of Q-axis driving mechanism 26 (nozzle rotating mechanism) is rotatably inserted through and the Q-axis gear 27 rotates around R axis 22 by Q-axis motor 28.

As shown in FIG. 3, on the lower section of R axis 22, multiple (for example four) engaging members 31 are provided movably in the up/down direction in order to detachably engage and hold rotary head 11, and close to each engaging member 31, an air cylinder (not shown in the figure) which drives each engaging member 31 in the up/down direction is provided. Each engaging member 31 is respectively formed in an L shape or J shape and arranged at even intervals in a circumferential direction of R axis 22, and the direction of the claw section of each engaging member 31 is arranged so as to be facing in the same direction as the normal rotational direction (or the reverse rotational direction) of R axis 22.

On the other hand, rotary head 11 is provided with nozzle rotating gear mechanism 32 (refer to FIG. 4) for transmitting the rotational power of Q-axis gear 27 to each nozzle holder 12. Nozzle rotating gear mechanism 32 engages cylindrical gear 33 (tooth surface is not shown in the figure) which is rotatably held concentrically at the upper section of rotary head 11 and small gear 34 which is respectively attached to each nozzle holder 12, and by rotating small gear 34 of each nozzle holder 12 by rotating cylindrical gear 33 by Q-axis gear 27 of head holding unit 21, each nozzle holder 12 rotates around the shaft center of each nozzle holder 12 and thus the orientation (angle) of each component picked up by each suction nozzle 13 held by each nozzle holder 12 is corrected.

In order to insert R axis 22 of head holding unit 21 into cylindrical gear 33, the inner diameter of the cylindrical gear 33 is formed slightly larger than the outer diameter of R axis 22. In positions inside cylindrical gear 33 on the upper surface of rotary head 11, multiple elongated holes 35 for inserting through each engaging member 31 of R axis 22 are formed at even intervals in a circumferential direction, and on one side of each elongated hole 35, pin to be engaged 36 (member to be engaged) which is engaged by the claw section of engaging member 31 is fixedly penetrating in the radial direction of rotary head 11. To the side of pin to be engaged 36 of each elongated hole 35, a gap is maintained so that engaging member 31 can pass by in the up/down direction.

The component mounter is provided with a head placement section (not shown in the figure) on which rotary head 11 for exchange is placed. This head placement section is configured such that multiple types of rotary heads 11 can be placed. When attaching rotary head 11 placed on this head placement section to head holding unit 21, R axis 22 of head holding unit 21 is inserted into cylindrical gear 33 and each engaging member 31 of R axis 22 is inserted into each elongated hole 35 of rotary head 11, and each engaging member 31 is pulled up and held while each engaging member 31 is engaged with pin to be engaged 36 in each elongated hole 35 by rotating R axis 22 by the rotation of R-axis gear 24. On head holding unit 21, various different types of rotary heads 11 [refer to FIG. 2 (a), (b)] can be held and mounting head for single nozzle 38 [refer to FIG. 2 (c)] can be also held.

Z-axis driving mechanism (not shown in the figure) using Z-axis motor 37 (refer to FIG. 6) as a driving source is assembled on head holding unit 21 in addition to R-axis driving mechanism 23 and Q-axis driving mechanism 26, and the configuration is such that nozzle holder 12 is lowered at the predetermined stopping position of the rotational path of nozzle holder 12 by the Z-axis driving mechanism.

Head holding unit 21 of component pickup device 10 configured as above moves in the XYZ directions by being held on head moving device 20 of a component mounter. Control device 41 (refer to FIG. 6) of the component mounter, according to a production program, controls head moving device 20, R-axis motor 25 of head holding unit 21, Q-axis motor 28, and Z-axis motor 37, and as well as controlling the operation for a component supplied from feeder 42 set in a component mounter to be picked up and mounted on a circuit board, controls the operation for rotary head 11 on a head placement section to be held by head holding unit 21 and the operation for suction nozzle 13 on a nozzle placement section to be held by rotary head 11.

Because the component mounter of the present embodiment described above comprises a head placement section on which rotary heads 11 for exchange are placed and a nozzle placement section on which suction nozzles 13 for exchange are placed, and is configured such that rotary head 11 is exchangeably held on R axis 22 of head holding unit 21 moved by head moving device 20 and suction nozzle 13 is exchangeably held on nozzle holder 12 of rotary head 11, it is possible to perform automatic exchange of rotary head 11 and automatic exchange of suction nozzle 13 by appropriately selecting them and the time required for exchanging rotary head 11 or suction nozzle 13 can be shortened, thus the operation rate of a component mounter can be improved.

Also, in the present embodiment, because the configuration is such that R-axis driving mechanism 23 (head rotating mechanism) for rotating rotary head 11 and Q-axis driving mechanism 26 (nozzle rotating mechanism) for correcting the orientation of a component picked up by suction nozzle 13 by rotating suction nozzle 13 are assembled on head holding unit 21 which holds rotary head 11 exchangeably, R-axis driving mechanism 23 and Q-axis driving mechanism 26 can be shared for use for all rotary heads 11 for exchange and it is not required to assemble R-axis driving mechanism 23 or Q-axis driving mechanism 26 to rotary head 11 for exchange, thus enabling downsizing and cost reduction of rotary head 11 for exchange, and space saving for exchange work.

Further, in the present embodiment, because suction nozzle 13 is held mechanically in nozzle holder 12 by the engagement of engagement pin 14 at the suction nozzle 13 side and engagement groove 16 at the nozzle holder 12 side, positional deviation or dropping of suction nozzle 13 due to the inertia force can be prevented even if rotary head 11 is moved at a high speed. However, for the present invention, it is also acceptable for suction nozzle 13 to be held in nozzle holder 12 using a plunger or plate spring.

Also, because rotary head 11 is held mechanically in head holding unit 21 by the engagement of engaging member 31 at the head holding unit 21 side and pin to be engaged 36 at the rotary head 11 side, positional deviation or dropping of rotary head 11 due to the inertia force can be prevented even if rotary head 11 is moved at a high speed. However, for the present invention, it is also acceptable for rotary head 11 to be picked and held on head holding unit 21 using negative pressure suction force.

Furthermore, the present invention is not limited to the above embodiment, and various embodiments with changes that do not extend beyond the scope of the invention are possible such as it is acceptable to appropriately change, for example, the configuration of rotary head 11 engaged and held in head holding unit 21, or the configuration of suction nozzle 13 engaged and held in nozzle holder 12, or to have a configuration such that a head which does not rotate is held by a head holding unit.

### Reference Number List

- 10:: Component pickup device
- 11:: Rotary head (head)
- 12:: Nozzle holder
- 13:: Suction nozzle
- 14:: Engagement pin (engagement protruding section)
- 15:: Engagement cylindrical section
- 16:: Engagement groove
- 17:: Pressing member
- 18:: Spring
- 20:: Head moving device
- 21:: Head holding unit
- 22:: R axis
- 23:: R-axis driving mechanism (head rotating mechanism)
- 24:: R-axis gear
- 25:: R-axis motor
- 26:: Q-axis driving mechanism (nozzle rotating mechanism)
- 27:: Q-axis gear
- 28:: Q-axis motor
- 31:: Engaging member
- 32:: Nozzle rotating gear mechanism
- 33:: Cylindrical gear
- 34:: Small gear
- 35:: Elongated hole
- 36:: Pin to be engaged (member to be engaged)
- 37:: Z-axis motor
- 38:: Mounting head
- 41:: Control device
- 42:: Feeder

## Claims

1. A component mounter (10) equipped with
a head (11) configured to hold multiple suction nozzles (13) which are configured for picking up components;
a head holding unit (21) configured to mechanically and exchangeably hold the head (11);
a head moving device (20) configured to move the head (11) and the head holding unit;
a head placement section configured to place thereon different types of rotary heads (11) for exchange;
a head rotating mechanism (23) assembled on the head holding unit (21), and configured to rotate the head (11); and
a control device (41) which is configured to control the head moving device (20) so as to control the operation of attaching a head (11) placed on the head placement section to the head holding unit (21),
**characterized in that**
the head (11) comprises a plurality of nozzle holders (12) that are configured to exchangeably hold the suction nozzles (13);
the component mounter (10) is further equipped with a nozzle placement section configured for placing thereon nozzles (13) for exchange;
the control device (41) is configured to control the operation of attaching a suction nozzle (13) placed on the nozzle placement section to the respective head (11) which is held by the head holding unit (21);
a nozzle rotating mechanism (26) comprising a driving source (27) is assembled on the head holding unit (21) and is configured to correct the orientation of each component picked up by the suction nozzle (13) by rotating the suction nozzle (13), so that the nozzle rotating mechanism (26) can be shared for use for all rotary heads (11) for exchange,
wherein the head (11) is provided with a nozzle rotating gear mechanism (32) for transmitting rotational power of the driving source (27) to each nozzle holder (12), and
wherein the nozzle rotating gear mechanism (32) engages a cylindrical gear (33), which is rotatably held concentrically at an upper section of the head (11), and a gear (34), which is respectively attached to each nozzle holder (12).

2. The component mounter (10) according to claim 1, wherein a nozzle holder (12) for holding the suction nozzle (13) is lowerably held on the head (11); an engagement protruding section (14) is provided protruding to the side on the upper section of the suction nozzle (13); an engagement groove (16) with an inverted L shape or inverted J shape into which the engagement protruding section (14) is inserted from below is formed in an engagement cylindrical section which engages the upper section of the suction nozzle (13) in the nozzle holder (12); and a spring (18) to maintain the state in which the engagement protruding section (14) is engaged with the engagement groove (16) is provided in the nozzle holder (12).

3. The component mounter (10) according to claim 1 or 2, wherein a member to be engaged (36) is provided in a connecting section with the head holding unit (21) in the head (11); an L shape or J shape engaging member (31) which moves between an engagement position engaging with the member to be engaged and an engagement release position released from the engagement is provided on a lower section of the head holding unit (21); and an air cylinder which is a driving source to move the engaging member (31) between the engagement position and the engagement release position is provided on the head holding unit (21).

## Patentansprüche

1. Komponentenmontagevorrichtung (10), umfassend
einen Kopf (11), der konfiguriert ist, mehrere Saugdüsen (13) zu halten, die konfiguriert sind, Komponenten aufzunehmen;
eine Kopf-Halteeinheit (21), die konfiguriert ist, den Kopf (11) mechanisch und austauschbar zu halten;
eine Kopf-Bewegungsvorrichtung (20), die konfiguriert ist, den Kopf (11) und die Kopf-Halteeinheit zu bewegen;
einen Kopf-Anordnungsabschnitt, der konfiguriert ist, verschiedene Typen von Rotationsköpfen (11) zum Austausch darauf anzuordnen;
einen Kopf-Drehmechanismus (23), der an der Kopf-Halteeinheit (21) montiert ist und konfiguriert ist, den Kopf (11) zu drehen; und
eine Steuerungsvorrichtung (41), die konfiguriert ist, die Kopf-Bewegungsvorrichtung (20) zu steuern, um den Vorgang des Montierens eines Kopfes (11), der auf dem Kopf-Anordnungsabschnitt angeordnet ist, an der Kopf-Halteeinheit (21) zu steuern,
**dadurch gekennzeichnet, dass**
der Kopf (11) eine Vielzahl von Düsenhaltern (12) umfasst, die konfiguriert sind, die Saugdüsen (13) austauschbar zu halten;
die Komponentenmontagevorrichtung (10) ferner mit einem Düsen-Anordnungsabschnitt ausgestattet ist, der konfiguriert ist, Düsen (13) zum Austausch darauf anzuordnen;
die Steuerungsvorrichtung (41) konfiguriert ist, den Vorgang des Montierens einer Saugdüse (13), die auf dem Düsen-Anordnungsabschnitt angeordnet ist, an dem jeweiligen Kopf (11), der von der Kopf-Halteeinheit (21) gehalten wird, zu steuern;
ein Düsen-Drehmechanismus (26), der eine Antriebsquelle (27) umfasst, an der Kopf-Halteeinheit (21) montiert ist und konfiguriert ist, die Orientierung von jeder Komponente, die von der Saugdüse (13) aufgenommen ist, zu korrigieren, indem die Saugdüse (13) gedreht wird, sodass der Düsen-Drehmechanismus (26) zur Verwendung für alle Rotationsköpfe (11) zum Austausch gemeinsam verwendet werden kann,
wobei der Kopf (11) mit einem Düsen-Drehgetriebemechanismus (32) zum Übertragen einer Drehleistung der Antriebsquelle (27) zu jedem Düsenhalter (12) ausgestattet ist, und
wobei der Düsen-Drehgetriebemechanismus (32) in Eingriff mit einem zylindrischen Getriebeelement (33) steht, welches konzentrisch an einem oberen Abschnitt des Kopfes (11) drehbar gehalten wird, und einem Getriebeelement (34), welches jeweils an jedem Düsenhalter (12) montiert ist.

2. Die Komponentenmontagevorrichtung (10) gemäß Anspruch 1, wobei ein Düsenhalter (12) zum Halten der Saugdüse (13) absenkbar an dem Kopf (11) gehalten wird; ein Eingriffs-Vorsprungsabschnitt (14) bereitgestellt ist, der an dem oberen Abschnitt der Saugdüse (13) zur Seite vorsteht; eine Eingriffs-Nut (16) mit einer umgekehrten L-Form oder umgekehrten J-Form, in welche der Eingriffs-Vorsprungsabschnitt (14) von unten eingesetzt wird, in einem Eingriffs-Zylinderabschnitt ausgebildet ist, der sich in Eingriff mit dem oberen Abschnitt der Saugdüse (13) in dem Düsenhalter (12) befindet; und eine Feder (18) zum Aufrechterhalten des Zustands, in welchem sich der Eingriffs-Vorsprungsabschnitt (14) mit der Eingriffs-Nut (16) in Eingriff befindet, in dem Düsenhalter (12) bereitgestellt ist.

3. Die Komponentenmontagevorrichtung (10) gemäß Anspruch 1 oder 2, wobei ein einzugreifendes Element (36) in einem Verbindungsabschnitt mit der Kopf-Halteeinheit (21) in dem Kopf (11) bereitgestellt ist; ein Eingriffselement (31) mit einer L-Form oder J-Form, welches sich zwischen einer Eingriffsposition in Eingriff mit dem einzugreifenden Element und einer von dem Eingriff gelösten Eingriffs-Löseposition bewegt, an einem unteren Abschnitt der Kopf-Halteeinheit (21) bereitgestellt ist; und ein Luftzylinder, welcher eine Antriebsquelle zum Bewegen des Eingriffselements (31) zwischen der Eingriffsposition und der Eingriffs-Löseposition ist, an der Kopf-Halteeinheit (21) bereitgestellt ist.

## Revendications

1. Machine de montage de composants (10) équipé
d'une tête (11) configurée pour maintenir de multiples buses d'aspiration (13) qui sont configurées pour prélever des composants ;
d'une unité de maintien de tête (21) conçue pour maintenir la tête (11) de manière mécanique et interchangeable ;
d'un dispositif de déplacement de tête (20) configuré pour déplacer la tête (11) et l'unité de maintien de tête ;
d'une section de placement de têtes configurée pour placer dessus différents types de têtes rotatives (11) pour un remplacement ;
d'un mécanisme de rotation de tête (23) assemblé sur l'unité de maintien de tête (21) et configuré pour faire tourner la tête (11) ; et
d'un dispositif de commande (41) qui est configuré pour commander le dispositif de déplacement de tête (20) de manière à commander l'opération de fixation d'une tête (11) placée sur la section de placement de têtes sur l'unité de maintien de tête (21),
**caractérisée en ce que**
la tête (11) comprend une pluralité de supports de buse (12) qui sont configurés pour maintenir de manière interchangeable les buses d'aspiration (13) ;
la machine de montage de composants (10) est en outre équipé d'une section de placement de buses configurée pour placer dessus des buses (13) pour un remplacement ;
le dispositif de commande (41) est configuré pour commander l'opération de fixation d'une buse d'aspiration (13) placée sur la section de placement de buses sur la tête (11) respective qui est maintenue par l'unité de maintien de tête (21) ;
un mécanisme de rotation de buse (26) comprenant une source d'entraînement (27) est assemblé sur l'unité de maintien de tête (21) et est configuré pour corriger l'orientation de chaque composant prélevé par la buse d'aspiration (13) en faisant tourner la buse d'aspiration (13), de sorte que le mécanisme de rotation de buse (26) peut être partagé pour une utilisation avec toutes les têtes rotatives (11) pour un remplacement,
dans laquelle la tête (11) est munie d'un mécanisme à engrenage rotatif de buse (32) pour transmettre une puissance de rotation de la source d'entraînement (27) à chaque support de buse (12), et
dans lequel le mécanisme à engrenage rotatif de buse (32) met en prise un engrenage cylindrique (33), qui est maintenu de manière rotative et concentrique au niveau d'une section supérieure de la tête (11), et un engrenage (34), qui est respectivement fixé à chaque support de buse (12).

2. Machine de montage de composants (10) selon la revendication 1, dans lequel un support de buse (12) destiné à maintenir la buse d'aspiration (13) est maintenue plus bas sur la tête (11) ; une section en saillie de prise (14) est agencée en faisant saillie vers le côté sur la section supérieure de la buse d'aspiration (13) ; une rainure de prise (16) en forme de L inversé ou en forme de J inversé dans laquelle la section en saillie de prise (14) est insérée par dessous est formée dans une section cylindrique de prise qui met en prise la section supérieure de la buse d'aspiration (13) dans le support de buse (12) ; et un ressort (18) pour maintenir l'état dans lequel la section en saillie de prise (14) est en prise avec la rainure de prise (16) est agencé dans le support de buse (12).

3. Machine de montage de composants (10) selon la revendication 1 ou 2, dans lequel un élément à mettre en prise (36) est agencé dans une section de connexion avec l'unité de maintien de tête (21) dans la tête (11) ; un élément de prise (31) en forme de L ou en forme de J qui se déplace entre une position de prise en prise avec l'élément à mettre en prise et une position de libération de prise libérée de la prise est agencée sur une section inférieure de l'unité de maintien de tête (21) ; et un cylindre pneumatique qui est une source d'entraînement pour déplacer l'élément de prise (31) entre la position de prise et la position de libération de prise est agencé sur l'unité de maintien de tête (21).
